# EUROPEAN PATENT SPECIFICATION

(11) **EP 0 424 124 B1**
(45) Date of publication and mention of the grant of the patent: **11.09.1996**
(21) Application number: 90311399.1
(22) Date of filing: 17.10.1990
(51) Int. Cl.: G03F 7/004

(54) **Positive-acting photoresist compositions**
Positive arbeitende Fotolackzusammensetzungen
Compositions photoréserves positives

(30) Priority: 18.10.1989 GB 8923459
(43) Date of publication of application: 24.04.1991
(73) Proprietor: MINNESOTA MINING AND MANUFACTURING COMPANY, St. Paul, Minnesota 55133-3427 (US)
(72) Inventor: Hauri, Robert J., St. Paul, MN 55144 (US); Vogel, Dennis E., St. Paul, MN 55144 (US); Newman, Stephen, Herts. (GB)
(74) Representative: Bowman, Paul Alan

(56) References cited:
- EP-A- 0 146 411
- DE-A- 2 306 248
- FR-A- 2 305 757

## Description

This invention relates to positive-acting photoresist compositions and in particular to positive-acting resist compositions suitable for use in lithographic printing plates.

Recent advances in the manipulation of text and graphics at the pre-press stage have created a need for lithographic plates suitable for exposure by low-energy devices such as laser scanners and projection cameras. These devices frequently emit over a narrow wavelength range, and accordingly the sensitivity of a useful lithographic plate must not only be very high, so as to reduce scan times and exposure times to realistic levels, but must also be sensitised to match the output wavelength of the exposure device.

Apart from the sensitivity requirements, various other attributes are necessary for a resist to function as a high-speed positive plate. These include processing latitude, resolution, and press-life, all of which may be inter-related. Press-life is governed by (amongst other things) the durability and adhesion of the resin used to form the image; hence the widespread use of phenolic resins coated on anodised aluminium, especially as they may frequently be post-baked (following development) to further enhance the image durability.

With regard to processing latitude, the ideal composition would allow the exposed areas of the coating to dissolve rapidly and completely in the developer, leaving the unexposed areas unaffected. In practice, this is rarely, if ever, achieved, largely as a result of the use of phenolic resins which will always be attacked, to some extent, even when not further solubilised, by the alkaline developer. Part of the skill of positive plate making lies in adjusting the development conditions so that attack on the unexposed areas is minimised while maintaining efficient wash-out of the exposed areas. Parameters that may be varied include time of development, the temperature, and alkali content of the developer solution. At one extreme, if the development conditions are too aggressive, so much coating will be lost from the resin image that the press-life is reduced. At the other extreme, too mild development conditions will lead to incomplete dissolution of the exposed areas, causing background toning on press.

Over or under-development will also affect the resolution obtainable. High quality colour printing requires the reproduction of half-tone images with dots in the range 3% to 97% obtained via a 150 line screen, or finer. Therefore the development conditions must allow the shadow dots to be opened without excessive attack on the highlight dots which might cause them to be removed altogether. A convenient rule-of-thumb states that acceptable results are obtained if, under development conditions that produce complete dissolution of the exposed areas, coating weight loss from the unexposed areas is in the range of 5 to 15%.

From the point of view of convenience to the platemaker, it is desirable that the plate should possess sufficient development latitude to allow a range of developer concentrations or development times to be used, rather than being restricted to tightly-controlled conditions.

A number of negative acting resin-on-metal plates have been produced which possess good sensitivity, processing latitude, press-life and resolution, but as yet no corresponding positive-acting plate is commercially available, despite considerable patenting activity in the field of high-speed positive resists.

Positive-acting resists generally comprise a resin binder, e.g., a phenolic resin, which is readily soluble in a developer solution, e.g., aqueous alkali. To the resin is added one or more light-sensitive compounds which have the property of retarding or totally suppressing the dissolution of the resin in the developer. By exposure to light of the appropriate wavelength and intensity, the light-sensitive compounds are destroyed or converted to other chemical species which exert no insolubilising action or may even assist solubilisation. By this means, the original solubility of the resin is restored, the process being known as photosolubilisation.

Virtually all the commercially available positive resin-on-metal plates combine a phenolic resin with a light-sensitive quinone diazide (also known as a diazo oxide) as solubility inhibitor. This technology is described, for example, by Brinckman et al in "Unconventional Imaging Processes" (Focal Press, 1987 pp. 65-67). It has low sensitivity (about 10⁶ ergs/cm²) and cannot be sensitised beyond its intrinsic sensitivity range centred on the near UV.

European Patent Publication No. 146411 discloses the combination of an onium, preferably iodonium, salt and a phenolic resin as a positive-acting resist. This represents a considerable advance both in terms of speed (about 10⁵ ergs/cm²) and also in the capability to be sensitised throughout the visible spectrum and into the infrared. Nevertheless, further increases in speed are desirable and also the processing latitude of this system is insufficient for many applications.

The speed obtainable from two-component resists of this type is limited by the lack of any amplification of the initial photomical event. Negative-acting photopolymer resists achieve higher sensitivities by virtue of the fact that a single quantum of absorbed light can initiate a chain reaction that produces tens or hundreds of insolubilising bonds. Therefore, in recent years, a number of photocatalytic solubilising systems have been proposed for high-speed positive resists, all exploiting reactions catalysed by photo-generated acid. These include the t-alkyl carbonate polymers described by Willson and Frechet (e.g., "Polymers in Electronics", ACS Symposium Series No. 242, pp. 11-23, Polymer Bulletin 17, pp. 1-6 [1987]; J. Imaging Sci. 30, pp. 59-64 [1986]). These contain t-alkyl carbonate groups either as pendant groups or within the polymer backbone, which cleave catalytically in the presence of photo-generated acid, causing either a marked polarity change (release of polar groups) or depolymerisation to soluble (or volatile) fragments. These materials are designed specifically for use as semiconductor masks, and are formulated simply with an onium salt as acid generator, i.e., they contain no additional phenolic resin as binder. Hence they are not suitable to function as printing plates with a realistic run-length.

There are various known resist compositions which contain three essential ingredients, namely a resin binder, a photo-acid source and a cleavable compound.

Research Disclosure 27721 (May 1987) (Agfa) discloses the combination of the carbonate polymers described above with an onium salt and a resin binder which is an aromatic vinyl polymer (e.g., polystyrene), not a phenolic resin. The Examples do not indicate how the plates are developed and the sensitivity quoted (Example 2) is 0.15 J/cm² (1.5 x 10⁶ ergs/cm²), which is very slow.

European Patent Publication No. 249139 discloses the combination of a phenolic resin, an onium salt and an acid-sensitive compound, where the last named is preferably a tert. butyl ester or a tert. butyl carbonate. The formulations are useful in the production of integrated circuits and the like. The highest sensitivities quoted in the visible or near-UV are 3 to 4 x 10⁵ ergs/cm².

German Patent No. 3,601,264 and Japanese Patent Application No. 62-059,949 disclose the combination of iodonium salt, phenolic resin binder, and respectively, a silyl ether compound and a silyl ureido compound. No information is given on resolution or development latitude. Formulations containing the silyl ether compound are shown to be up to 10 times faster than a diazo-oxide control.

U.S. Patent Nos. 4,247,611, 4,248,957, 4,250,247 and 4,311,782 disclose resist compositions comprising phenolic resins as binders, triazine derivatives and diazonium salts as acid sources, and, respectively, polyacetals/polyketals, enol ethers, N-acyliminocarbonates and polymeric orthoesters as cleavable compounds. According to the Examples, off-set plates produced by these methods require 20 seconds exposure to a 5kW lamp at 110 centimeters (15 seconds in the case of the poly[orthoesters]). There is no indication of the processing latitude or resolution. German Patent No. 3406927 discloses similar compositions where the binder is poly (hydroxy styrene) rather than a phenol formaldeyhde resin.

European Patent Publication No. 202196 and Research Disclosure No. 27331 (January 1987) (Anonymous) disclose the combination of a phenolic resin with an onium salt, together with cyclic acetals or ketals of beta-ketocarbonyl compounds or poly(phthalaldehyde). Additionally, the Research Disclosure discloses that other cleavable polymeric compounds may be used as the third component, giving improved speed and process latitude, but no specific details are given. Off-set plates disclosed in European Patent Publication No. 202196 required 60 second exposure to a 5kW source at 65 centimeters to clear 3 steps on a 0.15 increment grey scale. There is no teaching as to resolution or development latitude.

U.S. Patent No. 3,779,778 discloses the combination of phenolic resin, acid source and a variety of cleavable compounds, including pyranyl ethers of bisphenols. The acid source is a polyhalogen compound, preferably a polyhalogenated triazine derivative.

None of these prior art publications give any teaching as to the importance of the developer resistance of the unexposed material, or of how it may be maximised. The publications are only concerned with the photosolubility produced by the photocatalytic degradation of certain compounds.

It is an object of the present invention to provide a positive-acting photoresist composition of high sensitivity which may be sensitised to different wavelengths and possesses good development latitude.

Therefore according to the present invention there is provided a positive-acting photoresist composition comprising:
(i) an alkali-soluble binder comprising a plurality of phenol groups,
(ii) an iodonium salt of the general formula: 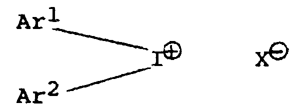 in which;
   Ar¹ and Ar² independently represent aromatic or heteroaromatic groups comprising up to 10 ring atoms, which groups may optionally be linked together to include the iodine atom within a ring structure and,
   X^{⊖} is an anion such that HX is an acid of pKa not greater than 3, and,
(iii) an acid cleavable compound having a nucleus of general formula (I): 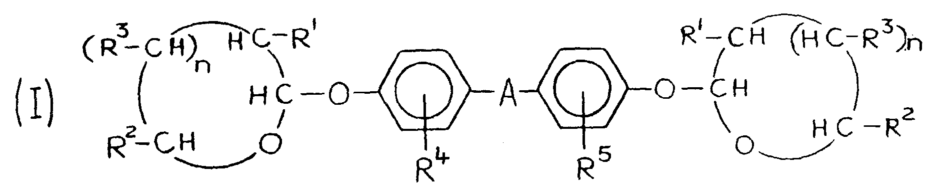 in which;

   n is 0, 1, 2 or 3,
   each R¹, R² and R³ independently represents hydrogen or an alkyl group comprising up to 4 carbon atoms,
   R⁴ and R⁵ independently represent hydrogen or one or more ring substituents selected from Cl, Br, F, alkyl groups comprising up to 4 carbon atoms, alkoxy groups comprising up to 4 carbon atoms and combinations thereof, and
   A represents a bond or a divalent linking group containing up to 10 atoms other than hydrogen.

The present invention provides a novel combination of photo-acid source and cleavable compound which apparently interact with each other to insolubilise an alkali-soluble binder, typically a phenolic resin. This unexpected phenomenon provides not only good developer resistance (the importance of which is described above, but is ignored in the prior art), but also high sensitivity, because the sensitivity ultimately depends on the magnitude of the solubility change associated with absorption of a given amount of light. The present system maximises this because it starts from a (relatively) highly-insoluble state, and converts via a photo-catalytic process, to a highly soluble state.

Because the insolubility stems from the interaction of two additives, removal of either one will bring about solubilisation. In this case one additive, the cleavable ether, is removed catalytically by acid generated by photolysis of the other, and so only a small fraction of the onium salt need be photolysed in order to bring about a catastrophic loss of developer-resistance. Experiments show that solubilisation can result from photolysis of less than 10% of the onium salt.

This is in contrast to the situation where a two component resist (onium salt and phenolic resin) is used, when not only is a higher loading of onium salt required to provide a useful degree of developer resistance, but also a higher percentage (≃50%) of the onium salt must be destroyed in order to restore solubility.

It has been found that the cleavable ethers on their own confer only a very limited amount of insolubility, and plates constructed from the cleavable ethers plus a non-interacting photo-acid source (e.g., a triazine derivative) show very poor development latitude.

Printing plates manufactured in accordance with the present invention show all the properties required for high quality colour reproduction, yet have a sensitivity measured as 10⁴ ergs/cm² at 405 nm. The printing plates require 1 second exposure to a 5 kilowatt source at 102 centimeters to clear 2 steps on a 0.15 increment step wedge, and speeds 30 times greater than a diazo oxide control are easily achieved.

The alkali-soluble binder may be chosen from a wide range of resins capable of forming tack-free coatings although phenolic resins such as phenol formaldehyde resins are preferred. Alternatively the binder may comprise a polymer or a copolymer of a hydroxy styrene derivative. Preferred phenolic resins include resole and novolac resins. A most preferred phenolic resin is m-cresol novolac resin. Mixtures of two or more types of resins may also be used, including those possessing additional alkyl substituents on the aromatic rings.

In the iodonium compound Ar¹ and Ar² are aromatic groups generally comprising from 4 to 10 carbon atoms, and may be selected from aromatic hydrocarbon rings, e.g., phenyl or naphthyl, and hetero-aromatic groups including thienyl, furanyl and pyrazolyl, and may be substituted with alkyl groups of up to 5 carbon atoms, e.g., methyl, alkoxy groups of up to 4 carbon atoms, e.g., methoxy, halogen atoms, e.g., chlorine, bromine, iodine and fluorine, carboxy, cyano or nitro groups, or any combinations thereof. Condensed aromatic-heteroaromatic groups, e.g., 3-indolinyl, may also be present.

Preferably Ar¹ and Ar² do not have more than two substituents at the α positions of the aryl groups. Most preferably Ar¹ and Ar² are both phenyl groups containing no α substituents.

Preferred groups for Ar¹ and Ar² include:

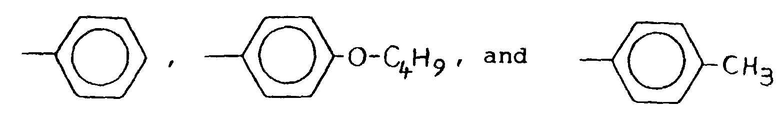

The α positions of the aryl groups may be linked together to include the iodine atom within a ring structure to give a formula such as: 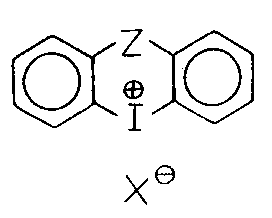 in which Z is an oxygen or sulphur atom and X^{⊖}is as defined above.

Many anions are useful as the counter-ion in the onium salt, provided the acid from which the anion is derived has a pKa of less than 3, preferably less than 1. Suitable inorganic anions include halide anions, HSO₄^{⊖}, and halogen-containing complex anions, e.g., tetrafluoroborate, hexafluorophosphate, hexafluoroarsenate and hexafluoroantimonate. Suitable organic anions include:

CF₃CO₂^{⊖}, CCl₃CO₂^{⊖}, CH₃SO₃^{⊖}, CF₃SO₃^{⊖}, CH₃C₆H₄SO₃^{⊖}

In the compound of Formula (I), n is preferably 1 or 2 and each of R¹ to R⁵ is hydrogen. A may represent a wide range of divalent groups including cyclic and linear groups generally composed of atoms selected from C, N,S,O and H. Preferred groups include:

-CH₂-, -SO₂-,

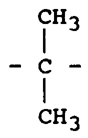

and other hydrocarbon bridge groups, preferably of up to 8 carbon atoms.

The compound of Formula (I) generally comprises from 5 to 30% by weight of the photoresist composition, preferably from 7.5 to 20% and most preferably from 10 to 15% by weight of the photoresist composition.

The iodonium salt generally comprises from 0.5 to 20% by weight of the photoresist compositions, preferably 1.0 to 10.0%, most preferably 2.0 to 5.0% by weight of the photoresist composition.

In addition to these 3 components, the formulation will also normally contain a sensitiser for the iodonium salt in order to increase the sensitivity of the system towards radiation of a wavelength longer than that of the intrinsic sensitivity of the iodonium itself. Many such compounds are known including those in the following classes: diphenylmethane including substituted diphenylmethane, such as amino substituted diphenylmethane, xanthene, acridine, methine and polymethine (including oxonol, cyanine and merocyanine), thiazole, thiazine, azine, aminoketone, porphyrin, aromatic polycyclic hydrocarbon, p-substituted aminostyryl compound, aminotriazylmethane, polyarylene, polyarylpolyene, 2,5-diphenylisobenzofuran, 2,5-diarylcyclopentadiene, diarylfuran, diarylthiofuran, diarylpyrrole, polyarylphenylene, coumarin and polyaryl-2-pyrazoline. The addition of a sensitiser to the system renders it sensitive to any radiation falling within the absorption spectrum of the sensitiser. The efficiency of the irradiation will increase the nearer it coincides with λ max of the sensitiser.

However, preferred sensitisers for use with the present invention do not interfere with the insolubilising action of the iodonium salt (e.g., by forming complexes with it, as may be found with some anionic dyes), nor scavenge the photo-generated acid necessary for the solubilising process, and so dyes possessing easily protonated groups are unlikely to be suitable. A preferred class of sensitisers are the polycyclic aromatic hydrocarbons and their derivatives, e.g., anthracene, 2-ethylanthracene, 9,10-diethoxyanthracene, 2-ethyl-9,10-diethoxyanthracene, etc.

The sensitiser is preferably present in an amount that makes maximum use of the incident light. This will vary according to the layer thickness, the extinction coefficient of the dye, and the extent to which its absorption spectrum matches the output of the exposing source, as is well understood by those skilled in the art. Generally the sensitiser will be present in amounts up to 15% by weight of the total solids composition. Where the output of the exposing source does not match the maximum absorption of the dye an amount in excess of this may be employed.

In most applications, the sensitiser is chosen so as to match as closely as possible the output of the intended exposure device, but in one embodiment, the sensitiser is chosen so that sensitivity is confined to the near UV region, with essentially no response to light of wavelengths greater than 400nm. This provides a plate that is handleable under white-light conditions, rather than requiring the yellow lighting normally used in the press-room, but can be imaged by conventional exposing devices with a realistic exposure time. Many commercially available exposing devices for printing plates emit predominantly in the blue region (above 400nm), with a relatively weak UV component, but such is the sensitivity shown by formulations in accordance with the present invention that inefficient exposures of this sort can be tolerated without unduly lengthening the exposure time. Sensitisers suitable for this application include anthracene and its 2-ethyl derivative.

The composition may additionally contain small amounts of other ingredients commonly incorporated in printing plate formulations, e.g., dyes or pigments that enhance the visibility of the post-exposure or post-development image, surfactants to improve the coatability, and oils or resins to improve the ink receptivity.

The composition will normally be coated on a hydrophilic substrate for use as a lithographic printing plate. A wide variety of coating solvents may be used, including lower alcohols, ketones, ethers and esters. Particularly suitable solvents are methyl ethyl ketone and methyl isobutyl ketone. Mixtures of solvents may also be used. Any of the well known coating techniques may be used, e.g., coating with wire-wound bars, spin-coating, knife-coating, dip-coating, roller-coating, etc.

Typical lithographic support materials which are useful in the invention include supports such as zinc, anodized aluminium, grained aluminium, copper and specially prepared metal and paper supports; superficially hydrolysed cellulose ester films; polymeric supports such as polyolefins, polyesters, polyamide and the like.

The supports can be sub-coated with known subbing materials such as copolymers and terpolymers of vinylidene chloride with acrylic monomers (such as acrylonitrile and methyl acrylate) and unsaturated dicarboxylic acids (such as itaconic acid or acrylic acid); carboxymethyl cellulose, polyacrylamide; and similar polymeric materials.

The support can also carry a filter or antihalation layer, such as one comprising a dyed polymer layer which absorbs the exposing radiation after it passes through the radiation-sensitive layer and eliminates unwanted reflection from the support. A yellow dye in a polymeric binder, such as one of the polymers referred to above as suitable sub-coatings, is an especially effective antihalation layer when ultraviolet radiation is employed as the exposing radiation.

In the manufacture of a printing plate, after coating, the composition is dried briefly at an elevated temperature, e.g., 3 minutes at 85°C. The resulting coating is surprisingly resistant to dissolution in alkaline developer. The combination of iodonium salt and cleavable compound engenders a greater developer-resistance than would be predicted from the behaviour of the individual components.

The plate is then exposed image-wise, using any suitable light source. Because of the high sensitivity shown by the plate, it is suitable for exposure by projection cameras and laser scanners. In the light-struck areas, a proportion of the iodonium salt is photolysed, generating the corresponding strong Bronsted acid HX. This acid catalyses the decomposition of compound (iii), releasing the corresponding bis-phenol derivative. The latter is highly soluble in alkaline developer and does not interact with the remaining unphotolysed iodonium salt to exert an insolubilising effect. Indeed, there is evidence to suggest that it decreases the insolubilising effect of the residual iodonium by competitive complexation. In any event, solubility inhibition by residual iodonium is slight because relatively small quantities of iodonium are present, even before photolysis takes place. Since the cleavage of compound of Formula (I) is a catalytic process, only a small proportion of the iodonium salt need be photolysed in order to destroy completely the developer resistance.

After exposure, the plate may be heated, e.g., to 85°C for 1 minute, to ensure completion of the cleavage reaction prior to development in aqueous alkaline developer and removal of the exposed areas of the coating. A wide range of alkaline solutions may be used, e.g., sodium hydroxide or trisodium phosphate solution, but the preferred developer is aqueous sodium metasilicate in the concentration range of 2 to 10 wt%, optionally containing small amounts of surfactants and/or organic solvents. After development, the plate is mounted on press and used to print copies in the normal manner.

Compositions of the invention may also be used as positive photoresists for the preparation of metal clad printed circuit boards, e.g., copper sheet laminated to an epoxy resin board. In this instance, the copper would be coated with the photosensitive composition. After exposure the solubilised material would be removed leaving an integral mask. Unprotected areas of copper would then be removed by etching such as with aqueous ferric chloride solution.

The compositions of the invention may also be used to protect other materials such as amorphous SiO₂. Silica is often used in the fabrication of electronic devices and integrated circuitry and the contact patterns for these devices are often defined through photomasks.

The compositions of the invention may also be used in other applications, e.g., proofing constructions in which the compositions contain a high loading of a colour-proofing pigment.

The invention will now be illustrated by the following Examples in which the following acid-cleavable compounds were used:-

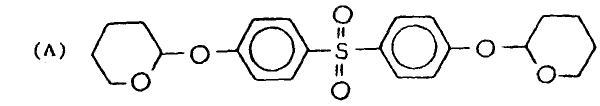

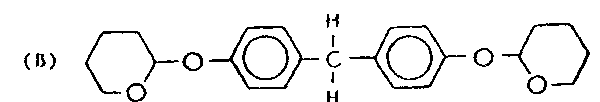

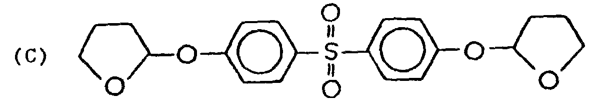

### Preparation of Compound (A)

A mixture of dihydropyran (85g), p-toluenesulphonic acid (0.1g) and concentrated HCl (2 drops) was stirred vigorously with ice-bath cooling as 4,4-sulphonyldiphenol (31.3g) was added in small portions. The resulting thick slurry was stirred for 3 hours at room temperature, diluted with 300ml ethyl acetate, and filtered to remove a small amount of insoluble material. The filtrate was extracted with 2N NaOH (3 x 50ml) and water (3 x 50ml), before drying over MgSO₄. The solvent was removed under reduced pressure until solid began to separate, whereupon a large volume of ether was added and the mixture was stored in the refrigerator until no more solid precipitated. The product was collected, washed with ether and dried in a vacuum oven. Yield 21.4g; melting point = 163 - 164°C.

### Preparation of Compound (B)

Compound (B) was prepared by a similar route from the appropriate diphenol, substituting light petroleum for ethyl acetate. The product was isolated by complete removal of the solvent, and was a viscous oil, partially crystallising on standing.

### Preparation of Compound (C)

To 200 ml of tetrahydrofuran (THF) (freshly distilled from benzophenone ketyl) in a nitrogen purged flask was added 8.6g (64mmol, 3.2eq) of sulfuryl chloride. A few drops of the sulfuryl chloride was added first and a slight exotherm was observed. The addition was continued at such a rate that the reaction temperature did not exceed 40°C. After the addition was complete the reaction mixture was stirred at 25°C for 15 minutes. This solution was then transferred to a dropping funnel and added simultaneously with a solution of 14.5g (144mmol, 7.2eq) of triethylamine in 20 ml of anhydrous THF to a mixture of 5.0g (20mmol, 1.0eq) of 4,4′-sulfonyldiphenol and 20ml of anhydrous THF in an atmosphere of nitrogen. During the addition the reaction was cooled with a water bath and then allowed to stir at 25°C for 2 hours. The reaction mixture was poured into an aqueous saturated solution of sodium carbonate and extracted with ether. The ether layer was dried with a mixture of Mg0 and MgSO₄ and concentrated in vacuo. The residue was triturated with a minimum amount of ether to give 6.1g (16mmol, 78% yield) of product. Melting point = 140-141°C; NMR (CDCl₃) 2.1(m,4H); 3.9(m,2H); 5.8(m,1H); 7.1(d,J=9Hz,2H); 7.8(d,J=9Hz,2H).

### Coating Procedures

All coatings were made with Borden m-cresol novolak resin as binder, using a 20% w/w solution in 2-butanone unless otherwise stated. Coatings were made on grained, anodised aluminium base (Cookson Graphics Inc, 1-A-1) using a wire-wound bar giving wet thickness of 12 µm (microns), then dried at 85°C for 3 minutes.

### Development

This was carried out in sodium metasilicate solutions of a given strength (e.g., 6% w/v) in a temperature controlled bath (22°C). The standard routine was a 1 minute immersion with intermittent rubbing with a lambswool pad, followed by rinsing in tap water.

### Coating Weight Loss (CWL)

This was measured as the percentage (by weight) of coating that was lost when an unexposed sample was subjected to the standard development routine.

### Speed

Unless otherwise indicated, exposures were carried out using a Nu-Arc model 40-6K contact frame, fitted with a 6kW metal halide lamp ("KT Ultra-plus instant start") at a distance of 102 centimeters from the easel. Under these conditions, one unit of exposure corresponds to an energy density of 2.8 x 10⁵ ergs/cm² integrated over the entire output wavelength range, or an exposure time of approximately 1.5 seconds. The bulk of the output of this lamp is above 400nm.

Samples were exposed to a given number of units, developed as described above and then inked by hand. This procedure comprises wiping the image first with 1% phosphoric acid, then with printing ink, the latter adhering preferentially to the undissolved resin image. The optical density at which photosolubilisation ceased was thus revealed, and by converting it to percentage transmission, it was possible to calculate the minimum exposure required to achieve photosolubilisation at 100% transmission, assuming no reciprocity failure.

### Example 1

This Example demonstrates the unexpected interaction between an iodonium salt and the acid-cleavable ethers of the invention which is believed to cause the improved speed and developer-resistance shown by the formulations of the invention.

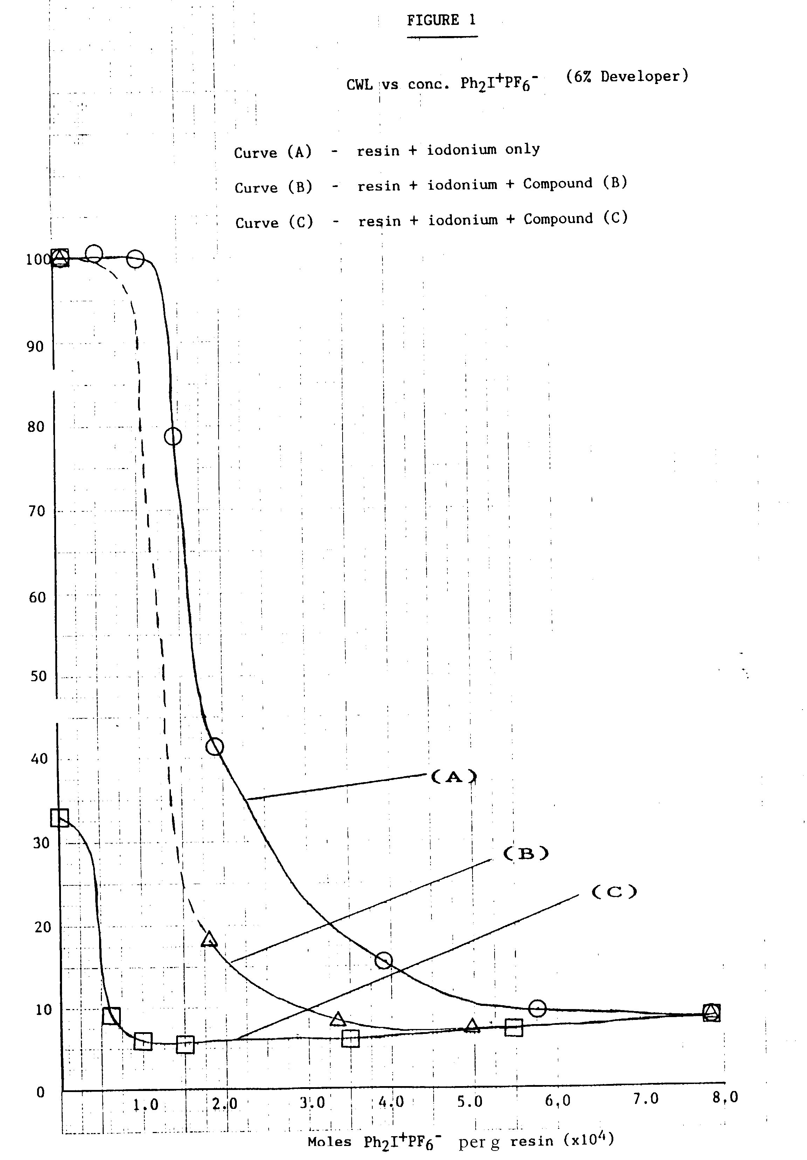

A series of coatings was prepared, comprising resin and iodonium salt (Ph₂I^{⊕}PF₆^{⊖}) only, the latter varying in concentration over the range 0 to 7.8 x 10⁻⁴ moles per gram of resin. The CWL in 6% developer was measured and plotted against the iodonium salt concentration, giving curve A of Figure 1 of the accompanying drawings. From these results it can be seen that a concentration of approximately 5 x 10⁻⁴ moles/g of iodonium salt is needed to reduce the CWL to the preferred value of 10%.

A second series of coatings was made, identical to the first, except that they additionally contained Compound (B) in the concentration range 7.8 x 10⁻⁴ to 0 moles/g,i.e., the total concentration of additive was constant at 7.8 x 10⁻⁴ moles/g, but its composition varied from 100% Compound (B) to 100% Ph₂I^{⊕}PF₆^{⊖} . The CWL in 6% developer was again measured and plotted against iodonium concentration, giving curve B of Figure 1.

These results show that Compound (B) on its own exerts no insolubilising effect towards 6% developer, yet in combination with the iodonium salt it somehow produces an enhanced developer resistance. A 10% CWL is achievable with approximately 2.5 x 10⁻⁴ Moles iodonium per gram of resin, about half the figure for resin and iodonium only. This indicates how it is possible to construct a plate where the developer resistance results from the combination of two ingredients, neither of which exerts a sufficient insolubilising effect on its own. Furthermore, one of these ingredients (the cleavable ether) is destroyed catalytically by the acid generated when a relatively small amount of the other ingredient (the iodonium salt) is photolysed. A very large solubility change can thus be achieved for a small amount of iodonium photolysis.

The experiment was repeated, substituting Compound (C) for Compound (B), resulting in curve C of Figure 1. In this case, the cleavable compound on its own exerts a measurable (but inadequate) insolubilising effect, but again the combination of the two ingredients produces a striking increase in developer resistance.

### Example 2

This Example demonstrates the superior speed and developer-resistance shown by formulations of the invention compared to the simple resin-iodonium combination.

The following three solutions were coated on Al base:-

| (a) 2.5g resin solution | (b) 2.5g resin solution | (c) 2.5g resin solution |
|---|---|---|
| 0.05g Ph₂I^{⊕} PF₆^{⊖} | 0.05g Ph₂I^{⊕}PF₆^{⊖} | 0.05g Ph₂I^{⊕}PF₆^{⊖} |
| | 0.10g Compound(A) | 0.10g Compound(B) |

Samples of each were exposed to 50 units through a Stouffer 21-step wedge and developed in 6% developer. Unexposed samples were tested for CWL in the same strength developer.

| Coating | CWL | Steps Cleared |
|---|---|---|
| (a) | 32.4% | 1 |
| (b) | 9.4% | 3 |
| (c) | 14.4% | 5 |

Thus, although the reference coating (a) was intrinsically more developer-sensitive (too sensitive for practical purposes), it gave less photosolubilisation than the coatings of the invention, which showed developer-resistances in the desired range.

### Example 3

This Example compares a formulation of the invention with the simple resin-iodonium combination in terms of speed and development latitude, and shows the high speeds available using the sensitiser 9,10-diethoxyanthracene (DEA). (The batch or resin used in this Example was less alkali-soluble than that used in the previous Examples).

Formulations were made as follows, and coated on Al base:

| | (a) | (b) |
|---|---|---|
| Resin solution | 2.5g | 2.5g |
| Ph₂I^{⊕}PF₆^{⊖} | 0.025g | 0.025g |
| DEA | 0.05g | 0.05g |
| Compound (A) | - | 0.10g |

Samples were tested for speed and CWL, using a variety of developer strengths, giving the following results:

| Coating | Developer Strength | CWL | Speed*(units) |
|---|---|---|---|
| | 3% | 11.9% | 5.0 |
| (a) | 4% | 15.9% | 1.0 |
| | 5% | 28.4% | - |
| | | | |
| | 6% | < 5% | - |
| (b) | 7% | 10.0% | 0.7 |
| | 8% | 12.0% | 0.6 |

| | | | |
|---|---|---|---|
| * minimum exposure to achieve photosolubilisation. | | | |

Not only do the coatings of the invention show higher speeds, but the performance is much less affected by changes in developer concentration.

### Example 4

This Example demonstrates the superior speed and development latitude shown by coatings of the invention compared to coatings in accordance with U.S. Patent No. 3,779,778 where the acid-generator is a triazine derivative rather than an iodonium salt. The following formulations were coated on Al base:

| | (a) | (b) |
|---|---|---|
| Resin solution | 2.5g | 2.5g |
| DEA | 0.05g | 0.05g |
| Compound (A) | 0.10g | 0.10g |
| MOST | 0.025g | - |
| Ph₂I^{⊕}PF₆^{⊖} | - | 0.025g |

(MOST = 2-(4-methoxystyryl)-4,6-bistrichloromethyl-1,3,5-triazine).

Samples were tested for speed and CWL using developers of various strengths, giving the following results:

| Coating | Developer Strength | CWL | Speed*(units) |
|---|---|---|---|
| | 2% | 4.1% | - |
| | 3% | 11.0% | 1.75 |
| (a) | 4% | 29.1% | - |
| | 5% | 76.8% | - |
| | 6% | 100% | - |
| | | | |
| | 3% | 7.2% | 1.4 |
| | 4% | 9.6% | 0.5 |
| (b) | 5% | 13.4% | 0.4 |
| | 6% | 25.0% | - |

| | | | |
|---|---|---|---|
| *min. exposure to achieve photosolubilisation | | | |

The coatings of the invention are much less affected by changes in developer concentration, and under conditions producing similar CWL's, significantly faster than the prior art coatings in accordance with U.S. Patent No. 3,779,778.

### Example 5

This Example demonstrates photosolubilisation of a formulation containing Compound (C).

The following mixture was coated on Al base:

| | |
|---|---|
| Resin | 0.60g |
| Ph₂I^{⊕}PF₆^{⊖} | 0.036g |
| Compound (C) | 0.09g |
| DEA | 0.018g |
| 2-butanone | 3.0ml |

Samples were exposed in a sensitometer through a 405nm narrow-cut filter, then developed in 5.6% developer. Unexposed samples gave CWL of less than 10% under these conditions. For the exposed samples, the energy requirement for photosolubilisation was measured as 2.0 mJ/cm² (2 x 10⁴ ergs/cm²).

### Example 6

This Example demonstrates a printing plate made in accordance with the invention and compares it with a commercially available diazo-oxide based plate.

The following formulation was micronised to achieve a good dispersion, then coated on anodised Al base:

| | |
|---|---|
| Resin solution | 5.0g |
| DEA | 0.15g |
| Compound (A) | 0.20g |
| Ph₂I^{⊕}PF₆^{⊖} | 0.05g |
| Monastral Blue GLA | 0.06g (Pigment available from Ciba Geigy) |

A sample was exposed through a 21-step Stouffer wedge to 20 units (approximately 1 second) on a Berkey Ascor contact frame, using a 5kW source at a distance of 1 meter. For comparison, a sample of "Endura P" positive plate commercially available from Minnesota Mining and Manufacturing Company was similarly exposed to 600 units. Both samples were heated for 1 minute at 85°C and then developed for 1 minute in 5.6% developer at 22°C. Both gave 2 clear steps with shadowing in the third, indicating that the plate of the invention was 30 times faster.

Plates in accordance with the invention, made by the above method were imaged, developed and then evaluated on a conventional off-set printing press. The plates ran cleanly, with a good ink-water balance. Accelerated wear tests indicated a projected run length of 200,000 impressions for an un-baked plate.

### Example 7

This Example demonstrates the capability of plates made in accordance with the invention to be imaged by a high-resolution projection camera with a relatively short exposure time.

A plate made as described in Example 6 was exposed on an Opticopy DTP 48/60 projection camera, fitted with a 1kW light source, where the projected image was that of an UGRA half-tone screen and microline target. Following an exposure of 15,000 units (13.2 seconds), the plate was heated for 1 minute at 85°C and then developed for a further minute in 5.6% developer at 22°C. Finally the plate was inked by hand. It was possible to detect dots in the range 99% to 0.5% on a 150 line screen, and to resolve the 8 micron lines. Under these conditions, the minimum exposure needed to clear the background was 7.6 seconds.

The experiment was repeated with the camera modified in that it was fitted with a 5kW source and had a diffusing screen (made of translucent glass) placed between the source and the image target. The diffuser is believed to be necessary for many commercial applications to avoid the reproduction of any scratches, dust etc., on the target transparency. However, it also has the unwanted effect of reducing the resolution available by a small amount, and reducing the light power available at the easel by a factor of 8 to 9. Plates of high sensitivity are therefore required if the exposure time is to be of a reasonable length (e.g., 30 seconds or less), and they must not cause further degradation of the resolution.

A plate prepared as described in Example 5 required 24 seconds exposure under these conditions to achieve optimum photosolubilisation (with processing as detailed above). Dots in the range 98% to 2% (150 line screen) were resolved.

### Example 8

This Example demonstrates the use of a different sensitiser, namely, 2-ethylanthracene (EA), conferring sensitivity in the near UV region of the spectrum, rather than the blue. This provides a plate that can be handled in white light for significant periods of time without affecting the exposure characteristics, yet requires a relatively short exposure on a conventional contact frame.

The following formulation was milled to disperse the pigment and then coated on Al base:

| | |
|---|---|
| Resin solution | 10.0g |
| Ph₂I^{⊕}PF₆^{⊖} | 0.2g |
| Compound (B) | 0.4g |
| EA | 0.2g |
| Irgalite Blue GLV | 0.12g (blue pigment available from Ciba Geigy) |
| methyl isobutyl ketone | 2.0g |

A sample exposed on the Nu-Arc printing frame required 6.3 units exposure (approximately 10 seconds) to achieve photosolubilisation. (Development was in 4% developer; CWL of unexposed material - 9.7%).

Samples were left on the laboratory bench for various lengths of time, exposed to the normal white fluorescent lighting and then tested for CWL along with a control kept under yellow lights. Samples exposed to white light for up to 20 minutes showed no increase in CWL compared to the control, indicating that no significant photochemical activity took place during this period. Longer exposures to white light produced progressively increasing CWL's. For comparison, a sample coating from Example 6 was similarly tested and it was found that 10 minutes white light exposure caused a two-fold increase (10% to 20%) of the CWL.

## Claims

1. A positive-acting photoresist composition comprising:
(i) an alkali-soluble binder comprising a plurality of phenol groups,
(ii) an iodonium salt of the general formula: 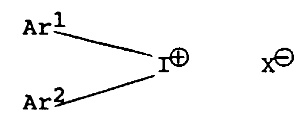 in which;
Ar¹ and Ar² independently represent aromatic or heteroaromatic groups comprising up to 10 ring atoms, which groups may optionally be linked together to include the iodine atom within a ring structure and,
X^{⊖} is an anion such that HX is an acid of pKa not greater than 3, and,
(iii) an acid cleavable compound having a nucleus of general formula (I): 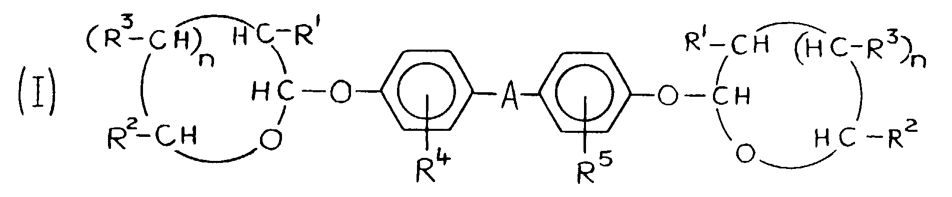 in which;
n is 0, 1, 2 or 3,
each R¹, R² and R³ independently represents hydrogen or an alkyl group comprising up to 4 carbon atoms,
R⁴ and R⁵ independently represent hydrogen or one or more ring substituents selected from Cl, Br, F, alkyl groups comprising up to 4 carbon atoms, alkoxy groups comprising up to 4 carbon atoms and combinations thereof, and
A represents a bond or a divalent linking group containing up to 10 atoms other than hydrogen.

2. A positive-acting photoresist composition as claimed in Claim 1 in which;
n is 1 or 2,
R¹ to R⁵ are hydrogen, and
A represents a bond,-CH₂-, -SO₂- or

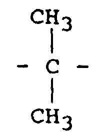

3. A positive-acting photoresist composition as claimed in Claim 1 in which the compound of Formula (I) is selected from: 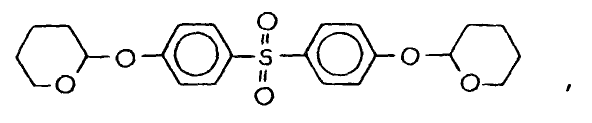 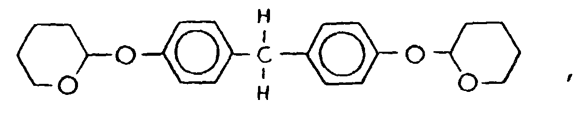 and

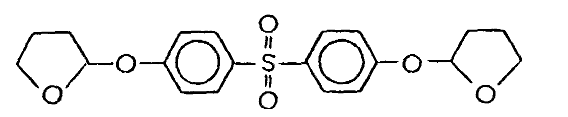

4. A positive-acting photoresist composition as claimed in any one of Claims 1 to 3 in which the alkali-soluble binder is selected from resoles, novolacs and mixtures thereof.

5. A positive-acting photoresist composition as claimed in any preceding Claim in which:
Ar¹ and Ar² are independently selected from: 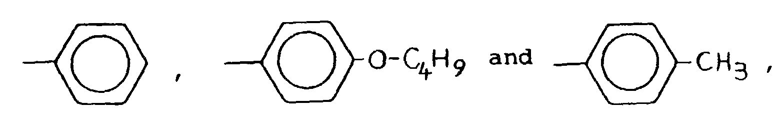 and
X^{⊖} is selected from PF₆^{⊖}, AsF₆^{⊖}, SbF₆^{⊖}, CF₃SO₃^{⊖}, CF₃CO₂^{⊖} and CH₃C₆H₄SO₃^{⊖}.

6. A positive-acting photoresist composition as claimed in any preceding claim in which the iodonium salt comprises from 0.5 to 20.0% by weight of the composition.

7. A positive-acting photoresist composition as claimed in any preceding claim in which the compound of Formula (I) comprises from 5 to 30% by weight of the composition.

8. A positive-acting photoresist composition as claimed in any preceding claim further comprising a sensitiser.

9. A positive-acting photoresist composition as claimed in Claim 8 in which the sensitiser comprises up to 15% by weight of the total solids content of the photoresist compositions.

10. A positive-acting photoresist composition as claimed in Claim 8 or Claim 9 in which the sensitiser is 9,10 diethoxyanthracene or a derivative thereof.

11. A radiation-sensitive element comprising a substrate bearing a positive-acting photoresist composition as claimed in any one of Claims 1 to 10.

12. A radiation-sensitive element as claimed in Claim 11 in the form of a printing plate.

## Patentansprüche

1. Positiv arbeitende Photoresistzusammensetzung, umfassend:
(i) ein basenlösliches Bindemittel, das eine Mehrzahl von Phenolgruppen umfaßt,
(ii) ein Jodoniumsalz der allgemeinen Formel: 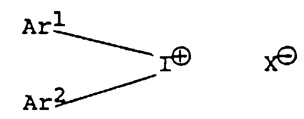 in der
Ar¹ und Ar² unabhängig aromatische oder heteroaromatische Reste darstellen, die bis zu 10 Ringatome umfassen. wobei die Reste gegebenenfalls aneinander gebunden sein können, wobei sie das Jodatom in die Ringstruktur einschließen, und
X^{⊖} ein solches Anion ist, daß HX eine Säure mit einem nicht größeren pKa-Wert als 3 ist, und
(iii) eine durch Säure spaltbare Verbindung mit einer Grundstruktur der allgemeinen Formel (I): 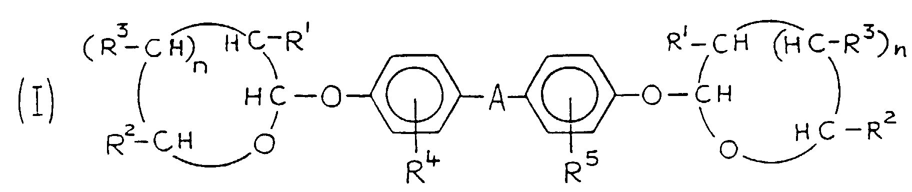 in der:
n 0, 1, 2 oder 3 ist.
jeder der Reste R¹, R² und R³ unabhängig ein Wasserstoffatom oder einen Alkylrest mit bis zu 4 Kohlenstoffatomen darstellt
R⁴ und R⁵ unabhängig ein Wasserstoffatom oder einen oder mehrere Ringsubstituenten, ausgewählt aus Cl, Br, F, Alkylresten mit bis zu 4 Kohlenstoffatomen. Alkoxyresten mit bis zu 4 Kohlenstoffatomen und Kombinationen davon, darstellen, und
A eine Bindung oder eine zweiwertige Bindungsgruppe, die bis zu 10 andere Atome als Wasserstoffatome enthält. darstellt.

2. Positiv arbeitende Photoresistzusammensetzung nach Anspruch 1, in der
n 1 oder 2 ist.
R¹ bis R⁵ Wasserstoffatome sind. und
A eine Bindung, -CH₂-, -SO₂- oder 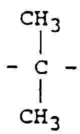 darstellt.

3. Positiv arbeitende Photoresistzusammensetzung nach Anspruch 1, in der die Verbindung der Formel (I) ausgewählt ist aus 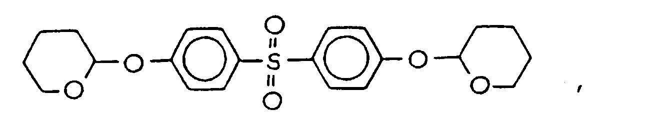 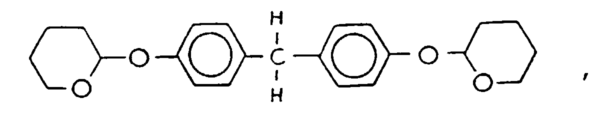 und

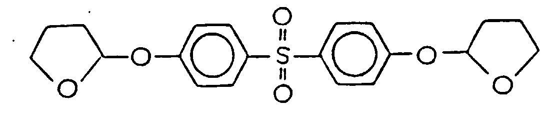

4. Positiv arbeitende Photoresistzusammensetzung nach einem der Ansprüche 1 bis 3. in der das basenlösliche Bindemittel aus Resolen, Novolaken und Gemischen davon ausgewählt ist.

5. Positiv arbeitende Photoresistzusammensetzung nach einem der vorstehenden Ansprüche. in der:
Ar¹ und Ar² unabhängig ausgewählt sind aus: 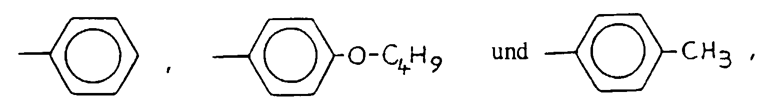 und
X^{⊖} ausgewählt ist aus PF₆^{⊖}, AsF₆^{⊖}, SbF₆^{⊖}, CF₃SO₃^{⊖}, CF₃CO₂^{⊖} und CH₃C₆H₄SO₃^{⊖}.

6. Positiv arbeitende Photoresistzusaminensetzung nach einem der vorstehenden Ansprüche, in der das Iodoniumsalz 0.5 bis 20.0 Gew.-% der Zusammensetzung ausmacht.

7. Positiv arbeitende Photoresistzusaminensetzung nach einem der vorstehenden Ansprüche. in der die Verbindung der Formel (I) 5 bis 30 Gew.-% der Zusammensetzung ausmacht.

8. Positiv arbeitende Photoresistzusammensetzung nach einem der vorstehenden Ansprüche, die ferner einen Sensibilisator umfaßt.

9. Positiv arbeitende Photoresistzusammensetzung nach Anspruch 8, in der der Sensibilisator bis zu 15 Gew.-% des gesamten Feststoffgehalts der Photoresistzusammensetzungen ausmacht.

10. Positiv arbeitende Photoresistzusammensetzung nach Anspruch 8 oder Anspruch 9, in der der Sensibilisator 9,10-Diethoxyanthracen oder ein Derivat davon ist.

11. Strahlungsempfindliches Element, umfassend einen Träger, der eine positiv arbeitende Photoresistzusammensetzung nach einem der Ansprüche 1 bis 10 trägt.

12. Strahlungsempfindliches Element nach Anspruch 11 in Form einer Druckplatte.

## Revendications

1. Composition photoréserve positive comprenant :
(i) un liant soluble dans un alcali comprenant plusieurs groupes phénols,
(ii) un sel d'iodonium de formule générale : 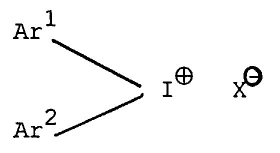 dans laquelle
Ar¹ et Ar² représentent indépendamment des groupes aromatiques ou hétéroaromatiques comprenant jusqu'à 10 atomes formant noyau, lesquels groupes peuvent éventuellement être liés ensemble pour inclure l'atome d'iode dans la structure de noyau et,
X^{⊖} est un anion tel que HX est un acide de pKa n'excédant pas 3, et
(iii) un composé qui peut être clivé par un acide ayant un noyau de formule générale (I) : 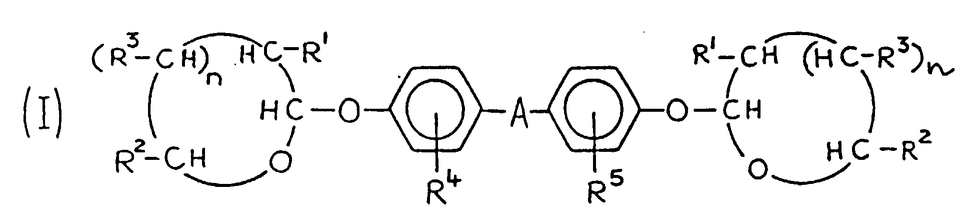 dans laquelle :
n est 0, 1, 2 ou 3,
chaque R¹, R² et R³ représente indépendamment un atome d'hydrogène ou un groupe alkyle comprenant jusqu'à 4 atomes de carbone,
R⁴ et R⁵ représentent indépendamment un atome d'hydrogène ou un ou plusieurs substituants à noyau choisis parmi Cl, Br, F, les groupes alkyle comprenant jusqu'à 4 atomes de carbone, les groupes alkoxy comprenant jusqu'à 4 atomes de carbone et leurs combinaisons, et
A représente une liaison ou un groupe de liaison bivalent contenant jusqu'à 10 atomes autres que des atomes d'hydrogène.

2. Composition photoréserve positive selon la revendication 1, dans laquelle :
n est 1 ou 2,
R¹ à R⁵ sont des atomes d'hydrogène, et
A représente une liaison, -CH₂-, -SO₂- ou

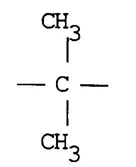

3. Composition photoréserve positive selon la revendication 1, dans laquelle le composé de formule (I) est choisi parmi: 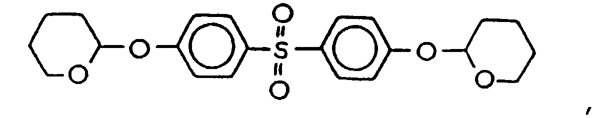 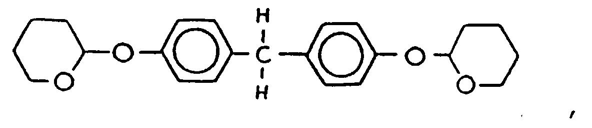 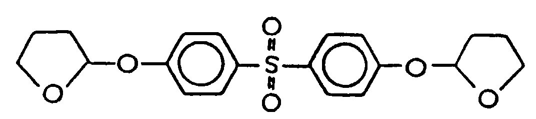 et

4. Composition photoréserve positive selon l'une quelconque des revendications 1 à 3, dans laquelle le liant soluble dans un alcali est choisi parmi les résols, les novolaques et leurs mélanges.

5. Composition photoréserve positive selon l'une quelconque des revendications précédentes, dans laquelle :
Ar¹ et Ar² sont indépendamment choisis parmi : 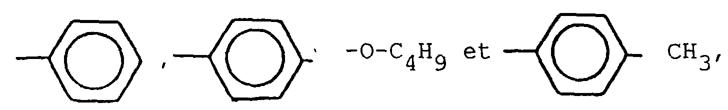 et
X^{⊖} est choisi parmi PFfI, AsF₆^{⊖} , SbF₆^{⊖}, CF₃SO₃^{⊖} , CF₃CO₂^{⊖} et CH₃C₆H₄SO₃^{⊖}.

6. Composition photoréserve positive selon l'une quelconque des revendications précédentes, dans laquelle le sel d'iodonium représente de 0,5 à 20,0% en poids de la composition.

7. Composition photoréserve positive selon l'une quelconque des revendications précédentes, dans laquelle le composé de formule (I) représente de 5 à 30% en poids de la composition.

8. Composition photoréserve positive selon l'une quelconque des revendications précédentes comprenant en outre un sensibilisateur.

9. Composition photoréserve positive selon la revendication 8, dans laquelle le sensibilisateur représente jusqu'à 15% en poids de la teneur totale en matières solides des compositions photoréserves.

10. Composition photoréserve positive selon la revendication 8 ou la revendication 9, dans laquelle le sensibilisateur est du 9,10-diéthoxyanthracène ou un de ses dérivés.

11. Elément sensible au rayonnement comprenant un substrat portant une composition photoréserve positive selon l'une quelconque des revendications 1 à 10.

12. Elément sensible au rayonnement selon la revendication 11, sous forme d'une plaque d'impression.
